# EUROPEAN PATENT APPLICATION

(11) **EP 0 930 619 A2**
(43) Date of publication of application: **21.07.1999**
(21) Application number: 98203872.1
(22) Date of filing: 13.11.1998
(51) Int. Cl.: G11C 5/14, G11C 11/407

(54) **A voltage reference circuit**

(30) Priority: 14.11.1997 US 65564
(71) Applicant: TEXAS INSTRUMENTS INCORPORATED, Dallas, TX 75265 (US)
(72) Inventor: Koelling, Jeffrey E., Dallas, Texas 75252 (US)
(74) Representative: Holt, Michael

(57) **Abstract**

A band-gap reference circuit (500) is disclosed which receives power from a first filter node (526) and a second filter node (528). In the preferred embodiment, the band-gap reference circuit (500) includes a reference stage (502), a first start-up circuit (504), and a second start-up circuit (506). The reference stage (502) generates a reference voltage (Vref). The start-up circuits (504 and 506) apply voltages to bias nodes within the reference stage (502) which enable the reference stage (502) to function at the lower voltages as the preferred embodiment (500) is powered up. To reduce the susceptibility of the band-gap reference circuit (500) to variations in the power supply voltages, such as those resulting from noise, a first filter (532) filters a first power supply voltage (Vcc) and applies the filtered voltage (Vccf) to the first filter node (526). A second filter (528) filters a second power supply voltage (Vss) and applies the filtered voltage (Vssf) to the second filter node (528).

## Description

### TECHNICAL FIELD

The present invention relates generally to semiconductor devices, and more particularly to circuits for generating reference voltages on semiconductor memory devices.

### BACKGROUND OF THE INVENTION

Semiconductor memory devices often require reliable reference voltages to establish predictable operation. Among the many types of regulated voltages are reduced internal power supply voltages. A reduced internal power supply voltage can be used to produce a semiconductor memory device that can operate at either a "high" external supply voltage or a "reduced" external supply voltage. The majority of the circuits within the memory device are designed to operate at a potential equal to the reduced external supply voltage. However, the memory device also includes voltage regulator devices that can receive the high external power supply voltage and generate therefrom, an internal supply voltage equal to the reduced external supply voltage. When the memory device is coupled to the reduced supply voltage, the voltage regulators are disabled and bypassed. Reduced internal power supply voltages may also be used for reliability reasons. As just one example, gate oxides of metal-insulator-semiconductor (MOS) transistors may not be able to reliably withstand a full voltage supply level, and so require a reduced internal power supply voltage.

Another reference voltage used in semiconductor devices is a reduced array voltage. A semiconductor memory device typically includes an array portion, which contains the memory cells and structures required to access the memory cells, such as bit lines and word lines, and a peripheral portion, which contains the timing, logic and driver circuits required to input data to, or output data from the array portion. A reduced array voltage is used to establish lower voltage levels in the array portion of a memory device, while a higher voltage is used in the peripheral portions of the memory device. Reduced array voltages can reduce power consumption, and improve reliability of the array portion.

For some types of semiconductor memory devices, dynamic random access memories (DRAMs) in particular, the reduced array voltage is used to write data into the memory cells. Accordingly, it is desirable to have a reliable reduced array voltage. If the memory cells are designed to operate at a particular voltage, a deviation in the reduced array voltage can result in substandard memory cell performance.

Another important reference voltage is a bit line reference (BLR) voltage. In many random access memory designs, memory cell data is coupled to a bit line to generate a data signal on the bit line. The potential of the data signal is compared with the BLR voltage to determine if the memory cell is storing a logic "1" or a logic "0." In the event the BLR voltage drifts, erroneous data sensing operations may result. BLR voltages can be generated from a reduced array voltage by a voltage divider circuit, or other voltage step-down approaches, such as "diode" connected MOS transistors.

Another reference voltage found in DRAMs is a "plate" voltage. DRAM memory cells usually each include a storage capacitor having a first plate and a second plate. The second plate of all, or a portion of, the memory cells in an array are coupled together, forming a plate node. The plate node can be maintained at a voltage greater than the low power supply. It is known in the prior art to maintain the plate node at the BLR voltage.

As noted above, reference voltages can be generated by using diode connected MOS transistors. A diode connected MOS transistor has its gate coupled to its source (or drain), and will not conduct unless its source-drain voltage exceeds the threshold voltage of the transistor. A drawback to such reference circuits is that the reference voltage they provide may drift with temperature.

One way to overcome the drawback of reference circuits based only on MOS transistors, is to employ a "band-gap" reference circuit. A band-gap reference circuit takes advantage of the fact that the base-emitter voltage (VBE) of a bipolar transistor has a negative temperature coefficient. That is, as the temperature increases, the VBE of a bipolar transistor will decrease. At the same time, the thermal voltage (VT) of the bipolar transistors, as well as resistor values, have positive temperature coefficients, and so can be used to compensate for drift in the VBE value. The output voltage at which a stable dc reference voltage can be maintained over considerable temperature variation turns out to be in the range of +1.25 volts. Band-gap reference circuits derive their name from this voltage, as it is close to the band-gap voltage of silicon.

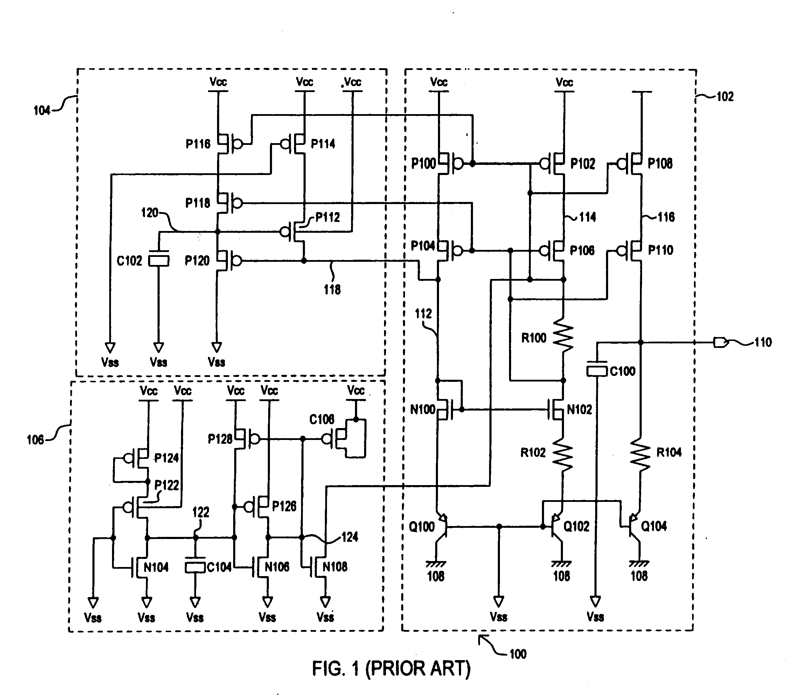

In order to understand the operation of the preferred embodiment, a prior art band gap reference circuit will be described in detail. Referring now to FIG. 1, the prior art band gap reference circuit is designated by the general reference character 100, and shown to include a reference stage 102, a first start-up circuit 104, and a second start-up circuit 106. The reference stage 102 includes a first pair of p-channel transistors, P100 and P102, a second pair of p-channel transistors, P104 and P106, and a pair of n-channel transistors N100 and N102. The drains of transistors P100 and P102 are coupled to the sources of transistors P104 and P106. The drain of transistor P104 is coupled to the drain of transistor N100.

The reference stage 102 further includes a resistor R100, a resistor R102, and two pnp bipolar transistors, Q100 and Q102. The resistor R100 is coupled between the drain of transistor P106 and the drain of transistor N102. Transistor Q100 has an emitter coupled to the source of transistor N100, a base coupled to the low power supply Vss, and a collector coupled to the substrate 108. Resistor R102 is coupled between the source of transistor N102 and the emitter of transistor Q102. The base of transistor Q102 is coupled to the low power supply Vss, and the collector is coupled to the substrate 108.

The last portion of the reference stage 102 set forth in FIG. 1, is a third leg, which includes the series connection of p-channel transistors P108 and P110, resistor R104 and pnp bipolar transistor Q104. Transistor P108 has a gate coupled to the gate of transistor P102, transistor P110 has a gate coupled to the gate of transistor P106, and transistor Q104 has a base connected to the low power supply Vss. The connection between the drain of transistor P110 and resistor R104 forms an output node 110. A capacitor C100 is coupled between the output node 110 and the low power supply voltage Vss.

Transistors P100, P102, P104, P106, P108, and P110 are of the same size. Transistors P100, P102 and P108 form a first current mirror stage. Similarly, transistors P104, P106 and P110 form a second current mirror stage. The first and second stages are arranged in a cascode connection. Unlike conventional cascade current mirror configurations, the common gate of transistors P100, P102, and P108 are connected to the drain of transistor P106. Similarly, the common gates of transistors P104, P106 and P110 are not connected directly to the drain of transistor P106, but instead are connected to the drain of P106 through resistor R100. The drain to source connections of transistor pairs P100/P102, P104/P106, and P108/P110 result in the gates of the transistors being maintained at approximately one threshold voltage below their respective drains. Thus, transistors P100, P102, P104, P106, P108 and P110 will reach saturation at lower supply voltages, allowing the reference stage 102 to be operational at lower supply voltages.

Transistors N100 and N102 also form a current mirror. The common gates of transistor N100 and N102 are coupled to the drain of transistor N100 in a conventional configuration.

The devices making up the reference stage 102 form three current legs. The first leg 112 includes the source-drain paths of transistors P100, P104, N100, and the emitter-collector path of Q100. The second leg 114 includes the source-drain paths of transistors P102, P106, N102, and the emitter-collector path of Q102. The third leg 116 includes the source-drain paths of transistors P108, P110, and the emitter-collector path of Q104. As noted above, the sizing of transistors P100, P102, P104, P106, P108 and P110 is the same, and so the amount of current in each of the three legs 112, 114 and 116, is the same.

Transistors Q100 and Q104 have the same sizing. Transistor Q102, in contrast, is created using eight bipolar transistors in parallel, each being the size of transistors Q100 and Q104. The value of resistor R102 and the differences in transistor sizes, results in the difference in the VBE between transistors Q102 and Q100, and establishes the value of the current flowing through each leg (112, 114 and 116). Thus, the voltage at the output node 110 is determined by the current running through each leg (112, 114 and 116), the value of resistor R104, and the VBE of transistor Q104.

The first and second start-up circuits (104 and 106) allow the reference stage 102 to ramp up with the power supply, when power is initially applied to the circuit 100. The first start-up circuit 104 is shown to include p-channel MOS starter transistors, P112 and P114, arranged in series between the high power supply Vcc and a starter node 118. The gate of transistor P114 is coupled to the low power supply Vss, and the gate of transistor P112 is coupled to a power-up node 120. Two p-channel MOS disable transistors P116 and P118 are coupled in series between the power-up node 120 and the supply voltage Vcc. A charge capacitor C102 and third p-channel MOS starter transistor P120 are coupled between the power-up node 120 and the supply voltage Vss.

As the device powers-up, the voltage at the starter node 118 is not sufficient to turn "ON" transistors N100 and N102. The reference stage 102, therefore, cannot provide a reference voltage that follows a ramping power supply voltage. The first start-up circuit 104 serves to pull the starter node 118 high, bringing the voltage at the starter node 118 more than one threshold voltage Vtn above the sources of transistors N100 and N102 as the power supply ramps up. Initially, the power-up node 120 is low, and transistors P112 and P114 will turn "ON", pulling the starter node 118 high. As the high power supply voltage rises, transistors P116 and P118 are turned "ON", and capacitor C102 charges, turning "OFF" transistor P112. The potential at the starter node 118 rises, disabling transistor P120.

The second start-up circuit 106 is shown to include a complementary MOS (CMOS) start-up inverter composed of p-channel MOS transistor P122 and n-channel MOS transistor N104. The common gates of transistors P122 and N104, and the source of transistor N104 is coupled to the supply voltage VSS. The source of transistor P122 is coupled to the supply voltage Vcc by a p-channel MOS transistor P124, which has a "diode" configuration. The source of transistor P124 is coupled is coupled to the supply voltage Vcc, the gate and drain of transistor P124 are coupled to the source of transistor P122. The common drains of transistors N104 and P124 are coupled to a disable node 122.

A capacitor C104 is coupled between the disable node 122 and the power supply VSS. The disable node 122 further serves as an input to CMOS disable inverter composed of p-channel MOS transistor P126 and n-channel MOS transistor N106. The common gates of transistors P126 and N106 are coupled to the disable node 122. The source of transistor N106 is coupled to power supply voltage VSS, and the source of transistor P126 is coupled to power supply voltage Vcc. The common drains of transistors P126 and N106 are coupled to a control node 124. A feedback p-channel MOS transistor P128 has a gate coupled to the control node 124, a source coupled to the power supply Vcc, and a drain that is fed back to the disable node 122. A pull-down transistor N108 and capacitor C106 are also coupled to the control node 124. Transistor N108 has a gate coupled to the control node 124, a source coupled to the power supply voltage Vss, and a drain coupled to the common gates of transistors P100 and P102 (and also the drain of transistor P106) within the reference stage 102. Capacitor C106 is coupled between the control node 124 and the power supply voltage Vcc.

The second start-up circuit 106 performs a similar function as the first start-up circuit 104. As power is initially applied to the circuit 100, transistors P100 and P102 within the reference stage 102 are turned "ON" by the second start-up circuit 106 to quickly establish a reference voltage. As in the case of transistors N100 and N102, transistors P100 and P102 will not initially be enabled as the power supply must rise to a considerable voltage before their gates will be more than one threshold voltage (Vtp) below their respective sources. The second start-up circuit 106 helps pull the gates of P100 and P102 to the lower voltage upon the power-up of the circuit 100.

Initially, capacitor C104 is discharged, and the disable node 122 is low. With the disable node 122 low, the transistor P126 will be turned "ON" as the power supply voltage rises. This results in control node 124 rising with the power supply, and turning "ON" transistor N108. As transistor N108 turns "ON", it discharges the common gates of transistors P100 and P102 to the supply voltage Vss. This arrangement maintains the common gates of transistors P100 and P102 at least one threshold voltage (Vtp) below their respective sources as the power supply ramps up. The rising voltage at the control node 124 and low voltage at the disable node 122 maintain feedback transistor P128 in the "OFF" condition.

As the positive power supply Vcc continues to rise, diode connected transistor P124 turns "ON", supplying a positive supply voltage to the CMOS inverter formed by transistors P122 and N104. Because the common gates of transistors P122 and N104 are tied to the supply voltage VSS, transistor P122 will be turned "ON", and begin to charge the capacitor C104 coupled to the disable node 122. As the potential at disable node 122 rises, transistor P126 turns off, and transistor N106 begins to turn on.

With transistor N106 turned "ON", capacitor C106 begins to charge, and the control node 124 is discharged to the supply voltage Vss. As the potential at the control node 124 falls, transistor N108 turns "OFF", and transistor P128 turns "ON". Transistor P128 latches the gate of N108 at the low power supply voltage.

Having described a prior art band-gap reference circuit 100, and the operation thereof, some drawbacks associated with the circuit 100 will now be discussed.

While the disclosed band-gap reference circuit 100 can supply steady reference voltages with constant power supplies, the reference voltage provided by the circuit can vary due to noise on the power supply lines. This can become an increasingly important problem as the higher operating speeds of memory devices, and increasing input/output (I/O) bit widths, can result in more noise on the power supply lines.

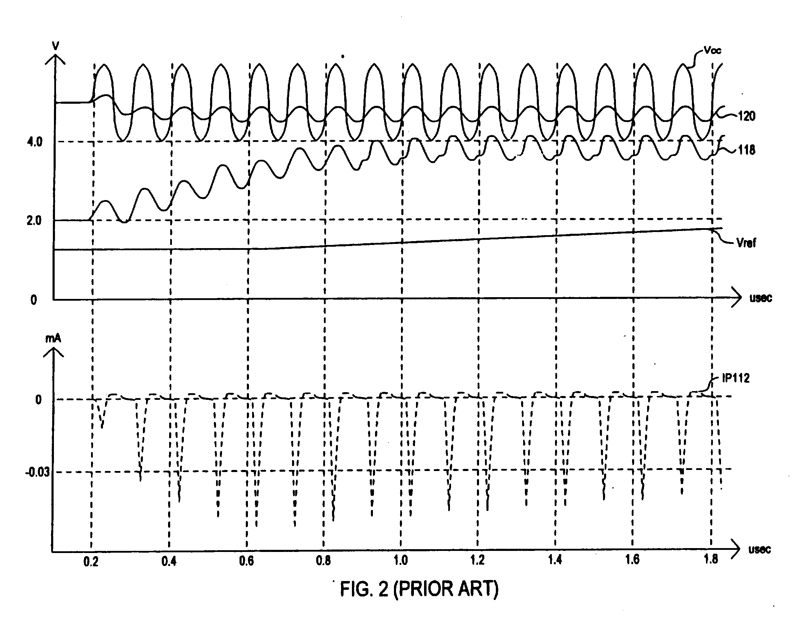

Referring now to FIG. 2, a series of waveforms are set forth illustrating the response of selected nodes and devices within the band-gap reference circuit 100 to variations on the power supply voltage, such as those that could be created due to noise.

Waveform Vcc illustrates a supply voltage that varies periodically. Waveform 120 illustrates the potential at node 120. Waveform 118 illustrates the potential at node 118. Waveform Vref represents the potential at the output node 108. The waveform IP112 represents the current flowing through transistor P112.

Transistor P114 has a gate coupled to the supply voltage Vss, and so remains "ON". As the Vcc voltage rises (for example due to noise), transistor P114 pulls the source of transistor P112 along with it. As the voltage at the source of transistor P112 rises, the magnitude of the gate-to-source voltage rises, and transistor P112 begins to turn "ON". This action is illustrated by the current waveform IP112 of FIG. 2.

With transistor P112 turning "ON", the starter node 118 rises in potential. As shown in FIG. 1, the starter node 118 is coupled to the common gate of transistors N100 and N102. As the starter node 118 rises in potential, the biasing of transistors N100 and N102 increases. This, in turn, lowers the gate potentials of the p-channel transistors P104, P106, and P110. In this manner the Vref voltage at the output node 108 increases. It is noted that transistor P112 has a rectifier-like response, turning on when noise forces the power supply voltage Vcc high, and turning "OFF" when the Vcc potential falls back down again.

The variation in the potential due to noise is also reflected at power-up node 120. As the potential at the common gates of transistors P104, P106 and P110 falls, and the Vcc voltage rises, the conductivity of transistors P116 and P118 increases, and the power-up node 120 rises in potential.

Thus, noise on the positive power supply of the band-gap reference circuit 100 can result in increases in the Vref potential, reducing the effectiveness of the circuit 100.

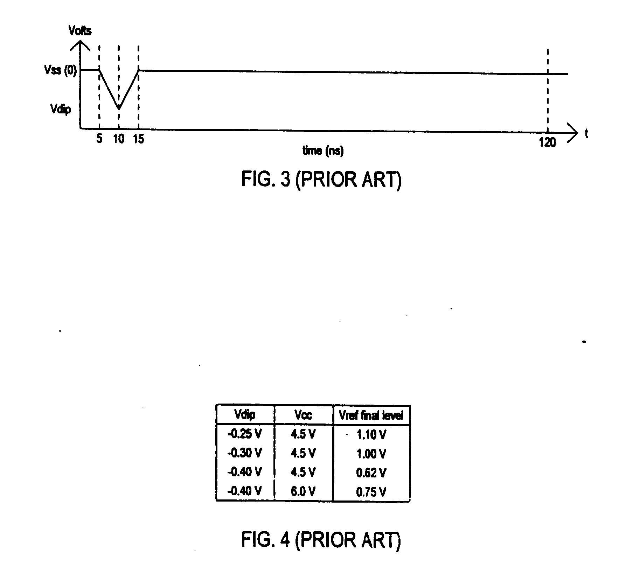

Variations in the low power supply voltage Vss of the band-gap circuit 100 of FIG. 1, can also lead to changes in the reference voltage. Referring now to FIG. 3, a waveform is set forth illustrating a dip in the low voltage power supply Vss. Such a dip may occur as a result of noise on the Vss power supply line. The dip is shown to occur between 5 and 15 nanoseconds, in a 120 nanosecond cycle. The resulting effect on the band-gap circuit 100 for various magnitude dips and power supply voltages is shown in table form in FIG. 4. The Vref final voltages represent the Vref voltage levels after repeated cycles of the waveform shown in FIG. 3.

It would be desirable to provide a band-gap reference circuit that is not as susceptible to noise on the power supply voltages.

### SUMMARY OF THE INVENTION

According to a preferred embodiment, a band-gap reference circuit is connected between a high power supply voltage and a low power supply voltage. The band-gap reference circuit further includes filter circuits for receiving external high and low power supply voltages. The filter circuits reduce the amount of noise on the power supply nodes of the band-gap reference circuit, and so reduce the adverse effects associated therewith.

According to one aspect of the preferred embodiment, the band-gap reference circuit includes a first power-up circuit for increasing the bias voltage to the gates of n-channel insulated gate field effect transistors (IGFETs) within the band-gap reference circuit when the band-gap reference circuit is powered-up. The first power-up circuit is coupled between the filtered high and low power supply voltages.

According to another aspect of the preferred embodiment, the band-gap reference circuit includes a second power-up circuit for decreasing the bias voltage to the gates of p-channel IGFETs within the band-gap reference circuit when the band-gap reference circuit is powered-up. The second power-up circuit is also coupled between the filtered high and low power supply voltages.

According to another aspect of the preferred embodiment, the band-gap reference circuit is included on a complementary metal-oxide-semiconductor (CMOS) integrated circuit, and the filters are designed to reduce spikes and dips resulting from the switching of CMOS circuits on the integrated circuit.

According to another aspect of the preferred embodiment, the filters of the band-gap reference circuit are first order resistor-capacitor filters.

### BRIEF DESCRIPTION OF THE DRAWINGS

The present invention will now be further described, by way of example, with reference to the accompanying drawings in which:
FIG. 1 is a schematic diagram illustrating a prior art band-gap reference circuit;
FIG. 2 is a timing diagram illustrating the effect of variations in the high power supply voltage of the band-gap reference circuit set forth in FIG. 1;
FIG. 3 is a timing diagram illustrating an example of a variation on the low power supply voltage of the band-gap reference circuit set forth in FIG. 1;
FIG. 4 is a table illustrating the effect of the variations in the low power supply voltage on the reference voltage of the band-gap reference circuit of FIG. 1;
FIG. 5 is a schematic diagram illustrating a preferred embodiment;
FIG. 6 is a timing diagram illustrating the response of the preferred embodiment to variations in the high power supply voltage; and
FIG. 7 is a timing diagram illustrating the response of the preferred embodiment to variations in the low power supply voltage.

### DETAILED DESCRIPTION OF THE EMBODIMENTS

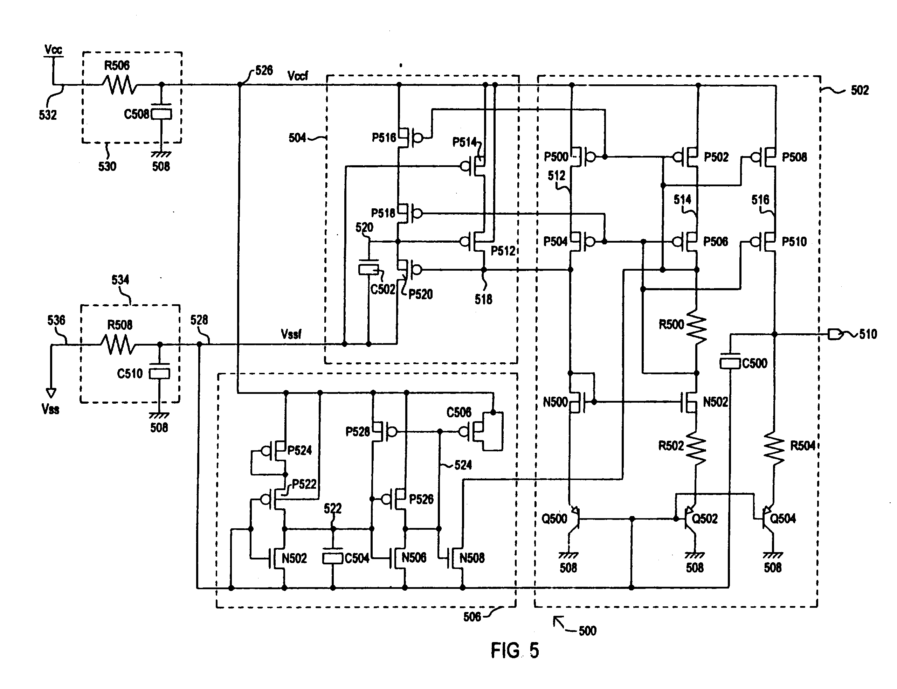

Referring now to FIG. 5, a schematic diagram is set forth illustrating a preferred embodiment. The preferred embodiment is a band-gap reference circuit, and is designated by the general reference character 500. The preferred embodiment 500 is shown to include many of the same circuit components as the prior art band-gap reference circuit 100 shown in FIG. 1. To that extent, like circuit components in FIG. 5 will be referred to by the same reference character, but with the first digit being a "5" instead of a "1". For example, the prior art circuit 100 includes a first leg 112 which includes the source-drain paths of p-channel metal-oxide-semiconductor (MOS) transistors P100 and P104, the source-drain paths of n-channel transistors N100, and the emitter-collector path of pnp bipolar transistor Q100. The preferred embodiment 500 has a corresponding first leg 512 which includes the source-drain paths of p-channel metal-oxide-semiconductor (MOS) transistors P500 and P504, of n-channel transistor N500, and the emitter-collector path of pnp bipolar transistor Q500.

The preferred embodiment 500 includes a reference stage 502 having the same general configuration as the reference stage 102 of the prior art circuit 100. Transistors P500, P502, P504, P506, P508, P510, N500 and N502 form current mirrors which set up identical currents in a first leg 512, second leg 514, and third leg 516. The current mirrors in combination with bipolar transistors Q500 and Q502 and resistor R502 establish the value of the current. The established current, runs through resistor R504 to create a reference voltage Vref at output node 510, and across capacitor C500.

The preferred embodiment 500 also includes a first start-up circuit 504 and a second start-up circuit 506. The first start-up circuit 504 has the same general configuration as the first start-up circuit 104 of the preferred embodiment 100. A power-up node 520 is initially low, when power is first applied to the preferred embodiment 500. With the power-up node 520 low, start-up transistors P514 and P512 will pull up starter node 518 as the device powers up. As the positive power supply increases, transistors P516 and P518 begin to turn "ON", charging capacitor C502, which then turns "OFF" transistor P512. The starter node 518 can be considered a bias node of the reference stage 502, as the potential at the node effects the operation of the devices making up the current mirrors. Thus, when the device is first powered up, the start-up circuit 504 initially applies a start voltage (Vccf) to the bias node as the starter node 518 tracks the rise in the high supply voltage of the circuit 500. Subsequently, the start-up circuit applies a bias voltage to the bias node. The bias voltage is the voltage that results when the first start-up circuit 504 is disabled and a full magnitude filtered power supply voltage (Vccf) is applied to the preferred embodiment 500.

The second start-up circuit 506 has the same general configuration as the second start-up circuit 106. Initially disable node 522 is discharged, and as the device initially powers-up, transistors P526 is turned "ON". This raises the voltage at control node 524, turning "ON" transistor N508. As the power supply voltage increases, transistor P522 is enabled, and charges control node 524 (and capacitor C504) through transistor P524. Transistor P526 is then turned "OFF", and transistor N506 is turned "ON", disabling transistor N508. Thus, in a similar manner to the first start-up circuit, the common gates of transistors P500 and P502 can also be considered a second bias node of the reference stage 502.

Unlike the prior art band-gap reference circuit 100, which is coupled between the high power supply voltage Vcc and low power supply voltage Vss, the preferred embodiment 500 is coupled between a high filter node 526 and a low filter node 528. A high filtered voltage Vccf is provided on the high filter node 526 by a first filter 530. The first filter 530 includes an input node 532 which receives the high power supply voltage Vcc, a resistor R506, coupled between the input node 532 and the high filter node 526, and a first filter capacitor C508, coupled between the high filter node 526 and the substrate 508.

A low filtered voltage Vssf is provided on the low filter node 528 by a second filter 534. The second filter 534 includes an input node 536 which receives the low power supply voltage Vss, a resistor R508, coupled between the input node 536 and the low filter node 528, and a capacitor C510, coupled between the low filter node 528 and the substrate 508.

The first and second filters (530 and 534) reduce the susceptibility of the band-gap reference circuit 500 to noise on the power supply voltages (Vcc and Vss) by reducing the amplitude of unwanted voltage spikes and voltage dips. The first and second filters (530 and 534) of the preferred embodiment are shown to be first order resistor-capacitor RC filters. It is understood that other filter types could be employed.

In the preferred embodiment, the values of the capacitors (C508 and C510) and resistors (R506 and R508) of the first and second filters (530 and 534) are the same. The resistors are selected to be 5 kohms, and the capacitors are selected to be 8.25 picofarads. This results in a time constant of 41.25 nanoseconds, and is aimed at reducing the typical voltage spikes and dips caused by the switching of CMOS devices. The first and second filters (530 and 534) are situated away from substrate contacts or other circuits that may be the source of substrate noise. Further, the first and second filters (530 and 534) are situated away from the other portions of the circuit 500.

In the preferred embodiment 500, the resistors (R506 and R508) of the first and second filters (530 and 534) are constructed by diffusing n-type dopants in a p-type substrate. The capacitors (C508 and C510) of the first and second filters (530 and 534) are constructed by diffusing n-type dopants in a p-type substrate to form one plate. The capacitor dielectric is formed from the same silicon dioxide gate dielectric used in the formation of the MOS transistors of the preferred embodiment 500. The other plate is formed using the same conductive gate materials used in the formation of the MOS transistors. The capacitor plate formed by the diffusion of the n-type dopants is coupled to the substrate. The other resistors (R500, R502 and R504) of the preferred embodiment 500 are formed by diffusing p-type dopants in an n-well, where the n-well is formed in the p-type substrate. It is understood that other embodiments could include resistive elements formed from transistors.

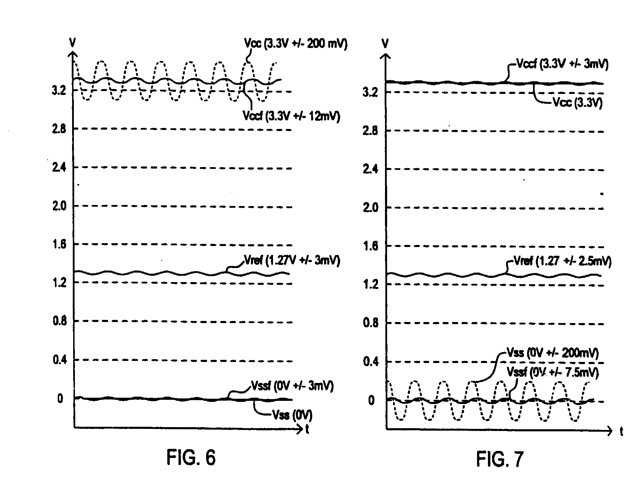

The response of the preferred embodiment 500 to variations in the power supply voltages, such as those that may be caused by noise, is set forth in FIGS. 6 and 7. FIG. 6 illustrates the response of the preferred embodiment 500 to variations in the high power supply voltage Vcc. The waveform identified as "Vcc" illustrates a positive supply voltage of 3.3 volts that varies by plus or minus 200 mV. The waveform identified as "Vccf" sets forth the resulting first filtered voltage on the first filter node 526. As shown in FIG. 6, the first filter 530 dampens the variations in the Vcc voltage, resulting in a Vccf voltage that is at 3.3 volts, plus or minus 12 mV.

In FIG. 6, the resulting reference voltage, shown by the waveform "Vref", does not rise in magnitude, as is the case of the prior art circuit 100. Instead, the Vref voltage centers around 1.27 volts, plus or minus 3 mV. While the low power supply voltage Vss is maintained at zero volts, the voltage on the second filter node 528 is shown to vary by plus or minus 3 mV around zero volts. Thus, the use of filters reduces the adverse affects of variations in the high power supply voltage.

FIG. 7 illustrates the response to the preferred embodiment 500, to variations in the low power supply voltage Vss. The waveform identified as "Vss" is shown to vary by 200 mV around the zero volt level. The voltage on the second filter node 528, shown by waveform "Vssf", illustrates the filtering effect of the second filter 534 on the varying low power supply voltage. Due to the second filter's effect, the Vssf waveform varies by plus or minus 7.5 mV around the zero volt level.

In FIG. 7, the output of the preferred embodiment 500, waveform "Vref", is shown to be centered around 1.27 volts, and to vary by plus or minus 2.5 mV. This is in contrast to the prior art response illustrated by FIG. 4, which results in Vref values below the desired 1.27 volt level. While the high power supply voltage in the case of FIG. 7 is maintained at 3.3 volts, the voltage at the first filter node 526, shown by waveform Vccf, varies around 3.3 volts by plus or minus 3 mV.
An alternate way of conceptualizing the preferred embodiment 500 is to consider the reference stage 502 as a band-gap circuit to which the first and second start-up circuits (504 and 506) apply start-up bias voltages. Accordingly, although the present invention has been described in detail, it should be understood that various changes, substitutions, and alterations could be made without departing from the spirit and scope of the invention.

## Claims

1. A voltage reference circuit formed in a semiconductor substrate, comprising:
a first filter coupled between a first power supply node and a first filter node; and
a band-gap reference circuit coupled between the first filter node and a second power supply node.

2. The voltage reference circuit of Claim 1, wherein:
the first filter includes a first filter resistor coupled between the first power supply node and the first filter node.

3. The voltage reference circuit of Claim 2, wherein:
the first filter resistor is formed by a diffusion region in a substrate.

4. The voltage reference circuit of any of Claims 1 to 3, wherein:
the first filter includes a first filter capacitor coupled between the first filter node and a substrate.

5. The voltage reference circuit of any of Claims 2 to 4, wherein:
the first filter response has a time constant of approximately 41.25 nanoseconds.

6. The voltage reference circuit of any of Claims 1 to 5, wherein:
the band-gap reference circuit includes a first bipolar transistor and a second bipolar transistor.

7. The voltage reference circuit of Claim 6, wherein:
the first and second bipolar transistors are pnp transistors having collectors regions coupled to the substrate, commonly connected base regions coupled to the second power supply node, an emitter region of the first bipolar transistor being coupled to a first current mirror node, an emitter region of the second bipolar transistor being coupled to a second current mirror node by a resistor.

8. The voltage reference circuit of any of Claims 1 to 7, wherein:
the first power supply node is arranged to provide a high power supply voltage.

9. The voltage reference circuit of any of Claims 1 to 7, wherein:
the first power supply node is arranged to provide a low power supply voltage.

10. The voltage reference circuit of any of Claims 1 to 9, further including:
a third power supply node; and
a second filter coupled between the third power supply node and the second power supply node.

11. The voltage reference circuit of Claim 10, wherein:
the second filter includes a third filter resistor coupled between the second power supply node and the second power supply node.

12. The voltage reference circuit of Claim 11, wherein:
the second filter resistor is formed by a diffusion region in a substrate.

13. The voltage reference circuit of any of Claims 10 to 12, wherein:
the second filter includes a capacitor coupled between the second power supply node and a substrate.

14. The voltage reference circuit of any of Claims 10 to 13, wherein:
the second filter response has a time constant of approximately 41.25 nanoseconds.

15. An integrated circuit reference voltage generator, comprising:
a band-gap reference circuit for receiving a first filtered supply voltage and a second supply voltage, and for generating a reference voltage that is dependent upon the base-emitter voltage and thermal voltage of bipolar transistors; and
a first filter for receiving a first power supply voltage and generating the first filtered supply voltage.

16. The integrated circuit reference voltage generator of claim 15, wherein:
the band-gap reference circuit includes
a current mirror circuit having at least a first bias node, and
a first start-up circuit for coupling the first bias node to the first filtered supply voltage as power is applied to the integrated circuit.

17. The integrated circuit reference voltage generator of Claim 16, wherein:
the first start-up circuit includes a first start-up capacitor device that is initially discharged when power is applied to the integrated circuit, and charged when the first filtered supply voltage reaches a maximum value.

18. The integrated circuit reference voltage generator of Claim 16 or 17, further including:
a second filter for receiving a second power supply voltage and for generating the second supply voltage, the second supply voltage being filtered by the second filter; and
the band-gap reference circuit includes
the current mirror circuit having a second bias node, and
a second start-up circuit for coupling the second bias node to the second supply voltage as power is applied to the integrated circuit.

19. The integrated circuit reference voltage generator of claim 18, wherein:
the second start-up circuit includes a second start-up capacitor device that is initially discharged when power is applied to the integrated circuit, and charged when the first filtered supply voltage reaches a maximum value.

20. The voltage reference circuit of any of Claims 15 to 19, wherein:
the first filter is a first order resistor-capacitor (RC) filter.

21. The voltage reference circuit of any of Claims 15 to 19 further including:
a second filter for receiving a second power supply voltage and for generating the second supply voltage therefrom, the second supply voltage being filtered the second filter.

22. The voltage reference circuit of any of Claims 18 to 21, wherein:
the second filter is a first order resistor-capacitor (RC) filter.

23. A circuit for generating a reference voltage having decreased susceptibility to power line noise, the circuit comprising:
a reference stage for generating a reference voltage, the reference stage including a bias node;
a start-up circuit coupled between a first filtered supply voltage node and a second supply voltage node, the start-up circuit coupling the bias node to the first filtered supply voltage when the first filtered supply voltage node rises upon power-up, and for applying a bias voltage to the bias node after the first filtered supply voltage has reached a predetermined value; and
a first filter for filtering a first power supply voltage to generate the first filtered supply voltage.

24. The circuit of Claim 23, wherein:
the first filter includes a first resistor-capacitor (RC) network.

25. The circuit of Claim 24, wherein:
the first RC network is a first order RC network.

26. The circuit of any of Claims 23 to 25, wherein:
the reference stage is coupled to the first filtered supply voltage.

27. The circuit of any of Claims 23 to 25, further including:
a second filter for filtering a second power supply voltage to generate the second supply voltage.

28. The circuit of Claim 27, wherein:
the second filter includes a second resistor-capacitor (RC) network.

29. The circuit of claim 28, wherein:
the second RC network is a first order RC network.

30. The circuit of any of Claims 27 to 29, wherein:
the reference stage is coupled to the second voltage.

31. The circuit of any of Claims 23 to 30, wherein:
the reference stage includes a band-gap reference circuit.
